# EUROPÄISCHE PATENTSCHRIFT

(11) **EP 1 451 874 B1**
(45) Veröffentlichungstag und Bekanntmachung des Hinweises auf die Patenterteilung: **14.11.2007**
(21) Anmeldenummer: 02791607.1
(22) Anmeldetag: 04.12.2002
(51) Int. Cl.: H01L 27/146, H01L 31/18

(54) **VERFAHREN ZUR HERSTELLUNG VON BILDSENSOREN**
METHOD FOR THE PRODUCTION OF IMAGE SENSORS
PROCEDE DE PRODUCTION DE CAPTEURS D'IMAGES

(30) Priorität: 07.12.2001 DE 10160234
(43) Veröffentlichungstag der Anmeldung: 01.09.2004
(73) Patentinhaber: STMicroelectronics N.V., 1118 BH Schiphol Airport Amsterdam (NL)
(72) Erfinder: LULE, Tarek, 38120 Saint-Egreve (FR)
(74) Vertreter: Hudler, Frank
(86) Internationale Anmeldenummer: PCT/DE2002/004439
(87) Internationale Veröffentlichungsnummer: WO 2003/054919

(56) Entgegenhaltungen:
- US-B1- 6 501 065
- LULE T ET AL: "SENSITIVITY OF CMOS BASED IMAGERS AND SCALING PERSPECTIVES" IEEE TRANSACTIONS ON ELECTRON DEVICES, IEEE INC. NEW YORK, US, Bd. 47, Nr. 11, November 2000 (2000-11), Seiten 2110-2121, XP000970481 ISSN: 0018-9383
- LULE T ET AL: "1000 000-PIXEL, 120-DB IMAGER IN TFA TECHNOLOGY" IEEE JOURNAL OF SOLID-STATE CIRCUITS, IEEE INC. NEW YORK, US, Bd. 35, Nr. 5, 1. Mai 2000 (2000-05-01), Seiten 732-739, XP001010995 ISSN: 0018-9200

## Beschreibung

Die Erfindung bezieht sich auf ein verfahren zur Herstellung von Bildsensoren auf Basis der TFA-Technologie mit einem amorphen Dünnschichtsystem, enthaltend ein Dünnschichtmaterial zur Bildung der Photodioden, das auf einem kristallinen ASIC aufgebracht worden ist, in dem Transistorstrukturen zur Steuerung der Photodiodenfunktion ausgebildet sind, die über Signalsammelknoten mit Photodioden verbunden sind, die im Dünnschichtmaterial pixelweise ausgebildet über Rückelektroden jeweils mit den Transistorstrukturen im ASIC verbunden sind.

Diese TFA-Technologie (Thin Film on ASIC), ist bekannt aus B. Schneider, P. Rieve, M. Böhm, Image Sensors in TFA (Thin Film on ASIC) Technology, ed. B. Jähne, H. Hausecker, F. Geißler, Handbook of Computer Vision and Applications, pp. 237-270, Academic Press, San Diego, 1999. Dünnschichtsysteme, die beispielsweise auf amorphem Silizium basieren können und auf dem kristallinem ASIC (Application Specific Integrated Circuit) aufgebracht worden sind, wandeln das einfallende Licht in einen Photostrom um, der von dem darunter liegendem ASIC weiter verarbeitet wird. Hierbei werden die optoelektronischen Vorteile des amorphen Materials mit den elektrischen Vorteilen des kristallinen Materiales kombiniert und genutzt. Es ist problemlos möglich, das Dünnschichtsystem generell auf jedem kristallinem ASIC aufzubauen, insbesondere geeignet sind ASICs auf der Basis der bekannten CMOS-Technologie (Complementary Metal Oxide Semiconductor). In dem ASIC werden dann die für den Bildsensorbetrieb nötigen Schaltungen realisiert.

Bei den herkömmlichen ASICs, die beispielsweise bekannt sind aus LULE T ET AL: "SENSITIVITY OF CMOS BASED IMAGERS AND SCALING PERSPECTIES" IEEE TRANSACTIONS ON ELECTRON DEVICES; IEEE INC. New York, US, Bd. 47, Nr. 11, November 2000 (2000-11), Seiten 2110-2112, XP0009790481 ISSN: 0018-9383 und aus LULE T ET AL: "1000 000-Pixel, 120-DB IMAGER IN TFA TECHNOLOGY" IEEE JOURNAL OF SOLID-STATE CIRCUITS, IEE INC: New York, US, Bd. 35, Nr. 5, 1. Mai 2000 (2000-05-01), Seiten 732-739, XP001010995 ISSN: 0018-9200, tritt dabei das Problem auf, dass in den kristallinen Bauelementen hohe Leckströme auftreten. Diese Leckströme überlagern sich den Photoströmen und variieren von Pixel zu Pixel sowie mit der Temperatur.

Da diese Leckströme von den weiteren Auswerteschaltungen des ASICs ebenso in Signale umgewandelt werden, wie die Photoströme, überlagern sich durch die Leckströme Störsignale auf die Nutzsignale, die insbesondere bei längeren integrationszeiten und niedrigen Beleuchtungsstärken als zeitliches Rauschen und als ortsfestes Rauschen (auch genannt FPN, Fixed Pattern Noise) im Bild störend sichtbar werden und damit die Bildqualität beeinträchtigen.

Dagegen ist der Leckstrombeitrag, der durch das Dünnschichtsystem beigesteuert wird oft wesentlich geringer und würde für sich allein genommen eine bessere Bildqualität bei niedrigen Beleuchtungsstärken bieten.

Der Erfindung liegt nunmehr die Aufgabe zugrunde, Bildsensoren auf Basis der TFA-Technologie zu schaffen, die bei niedrigen Beleuchtungsstärken dadurch eine bessere Bildqualität bieten, dass die Dunkelströme reduziert werden.

Die der Erfindung zugrunde liegende Aufgabe wird bei einem Verfahren der eingangs genanten Art dadurch gelöst, dass sämtliche Photo- und Leckströme in dem Signalsammelknoten sowie der direkt daran angeschlossenen Elemente zu einem Pixelsignal gesammelt werden und dass im kristallinen Substrat der Pixelstruktur ein Resettransistor ausgebildet ist, der Drain- und Sourcediffusionsgebiete und ein Gate umfasst, die von benachbarten Strukturen durch eine Isolationsschicht getrennt sind und wobei die Transistoren in tiefen Ebenen des Substrates mit unterschiedlichen Schwellspannungen ausgebildet werden.

In einer weiteren Fortführung der Erfindung ist vorgesehen, dass die Transistorstrukturen im kristallinen ASIC durch einen CMOS-Prozess hergestellt werden und dass das Dünnschichtsystem auf einem Detektor basiert, der aus amorphem Silizium hergestellt worden ist.

Es ist weiterhin von vorteil, wenn die Photodioden im Dünnschichtmaterial bildpunktweise in einer zweidimensionalen Matrix, oder in einer oder mehreren eindimensionalen Zeilen angeordnet werden.

Eine weitere Ausgestaltung der Erfindung besteht darin, die Transistorstrukturen pro Pixel so auszugestalten, dass diese unterschiedliche Schwellspannungen aufweisen.

Der erfindungsgemäße Herstellungs-Prozess basiert in der Regel auf einem kristallinen Standard-Prozess, der typischerweise in CMOS-Technologie ausgeführt wird aber auch auf anderen Basis-Prozessen basieren kann. Er zeichnet sich dadurch aus, dass der Standard-Prozess dahingehend optimiert wird, dass er für Bildsensoren geeignet wird. Zu den Optimierungen gehören:
1) Verfahren zur Senkung der Leckstromquellen im Pixel
2) Bildung einer Photodiode, die in jedem Pixel eingebaut wird, eine hohe Empfindlichkeit und selbst einen niedrigen Leckstrom aufweist, und
3) Bildung von Mikrolinsen auf der Oberfläche des Bildsensors zur Konzentrierung des Lichtes auf die oben genannte Photodiode.

Von den aufgelisteten Optimierungen ist die erste von großer Bedeutung für die erfindungsgemäße Bildung eines TFA-Bildsensors. Da diese Leckstromquellen bevorzugt in den Transistoren und Dioden zu suchen sind, die im kristallinen Basismaterial gebildet werden, sind die Verfahren typischerweise auf diese Bauelemente und die Herstellungsschritte anzuwenden, die zur Herstellung dieser Bauelemente durchgeführt werden.

Die für die Senkung der Leckströme eingesetzten Verfahrensschritte beinhalten beispielsweise die Verwendung von modifizierten Implantationsdosen und -energien, Änderung der Implantationsgeometrien oder Weglassen von einzelnen Herstellungsschritten, die für die Bildung eines Transistors im Standardprozess benötigt werden aber nicht für die Bildung eines Transistors für ein Pixel in einem Bildsensorprozess. Die Verfahrensschritte können von Prozess zu Prozess und von Hersteller zu Hersteller variieren und sind im Detail nicht von Bedeutung für die Bildung des TFA-Bildsensors. Wesentliche Eigenschaft der Verfahrensschritte ist die, dass die bei typischen Transistorstrukturen in der verwendeten ASIC-Technologie auftretenden Leckströme reduziert werden.

Alle weiteren aufgelisteten und nicht aufgelisteten Optimierungsmaßnahmen eines Bildsensorprozesses sind nicht notwendig für die vorteilhafte Verwendung des ASICs für einen TFA-Bildsensor, da sich diese ja gerade dadurch auszeichnen, dass die Photodiode auf der Oberfläche des ASICs in einem Dünnschichtprozess gebildet wird und nicht im ASIC-Prozess.

Für die erfindungsgemäße Lösung des Problems wird also ein Bildsensors dadurch gebildet, dass ein ASIC aufgebaut wird, der auf einem Bildsensorprozess beruht und von diesem Bildsensorprozess insbesondere die Verfahrensschritte angewendet werden, die zu einer Absenkung der Dunkelströme führen. Es können jedoch auch weitere Verfahrensschritte des Bildsensorprozesses angewendet werden, soweit sie für die Bildung des Bildsensors von Vorteil sind. Dazu gehört die Ausbildung von Transistoren im Pixel mit unterschiedlichen Schwellspannungen.

Nachdem der ASIC auf vorgenannte Weise aufgebaut wurde, wird der TFA-Prozess auf dem ASIC ausgeführt und damit der ASIC zum Bildsensor vervollständigt. Die wesentlichen Änderungen des vorbereiteten ASICs gegenüber einem ASIC, der in einem Standardprozess vorbereitet wurde, liegen in den tieferen Ebenen des Prozesses, den Ebenen in denen die Transistoren und Dioden liegen, die im kristallinen Material gebildet werden. Insbesondere unterscheidet sich die Oberfläche des ASICs, auf dem das TFA-System aufgebracht wird, nicht wesentlich von der Oberfläche eines ASICs aus einem Standardprozess, auf dem ein TFA-System aufgebracht wird.

Insbesondere daher ist das Herstellungsverfahren des TFA-Systems auf dem ASIC, der im Bildsensorprozess gefertigt wurde, dasselbe Herstellungsverfahren wie das, welches auf einem ASIC ausgeführt wird, der in einem Standardprozess gefertigt wurde. Der Aufbau des TFA-Systems unterscheidet sich also nicht von dem Aufbau eines TFA-Bildsensors auf Basis eines Standardprozesses.

Die vorteilhafte Eigenart dieses Bildsensors ist nun, dass die Vorteile der TFA-Technologie mit ausgewählten Vorteilen des Bildsensorprozesses kombiniert wurden. Insbesondere ist der Gesamtdunkelstrom der sich aus den Dunkelstrombeiträgen des ASIC und dem Dunkelstrom der TFA-Diode zusammensetzen niedriger als bei einem Bildsensor in TFA-Technologie auf der Basis eines Standard-Prozesses oder bei einem Bildsensor, der nur auf einem Standardprozess basiert.

Weitere vorteilhafte Eigenschaft der erfindungsgemäßen Vorrichtung ist die Tatsache, dass sie sich für Bildsensoren für sichtbares Licht genauso eignet wie für Bildsensoren, die andere Wellenlängen oder andere Strahlungsarten detektieren.

Weiterhin eignet sich die Erfindung für die Realisierung von Matrixsensoren ebenso wie für die Realisierung von Zeilensensoren.

Die Erfindung wird nachfolgend an einem Ausführungsbeispiel unter Bezugnahme auf die zugehörige Zeichnungsfigur weiter veranschaulicht.

Die Zeichnungsfigur zeigt den Querschnitt eines beispielhaften Pixels, das in TFA-Technologie auf der Basis der CMOS-Technologie realisiert wurde.

Das TFA-System 1 wird dabei auf dem kristallinen ASIC .2 (schematisch) aufgebaut. Es ist getrennt vom darunter liegenden ASIC durch eine Isolationsschicht 13. Auf diesem werden metallische Rückelektroden 12 aufgebracht und pixelweise strukturiert. Zwischen diesen Rückelektroden und der transparenten, leitfähigen Frontelektrode 10 befindet sich ein Dünnschichtmaterial 11; das beispielsweise aus amorphem Silizium gebildet wird.

Wesentliche Details des ASICs 2 für die Erfindung sind der Signalsammelknoten 24, auf dem alle Photo- und Leckströme zu dem Pixelsignal zusammengesammelt werden, und alle direkt daran angeschlossenen Elemente.

Dazu gehört die Transistorstruktur des Pixels 33 mit im kristallinen Substrat 2 ausgebildetem Resettransistor 20, gebildet aus den Drain- und Sourcediffusionsgebieten 21, 21a und dem Gate 22, der von benachbarten Strukturen durch die Isolationsschicht 32 getrennt ist. Der Resettransistor leitet die Photoladung vom Signalsammelknoten 24 auf eine Resetleitung 23 ab.

Dem Signalsammelknoten 24 nachgeschaltet sind zwei Transistoren; ein mit der Versorgungsspannung 29 verbundener Treibertransistor 25 und ein Auswahltransistor 26, die das gesammelte Signal verstärken und dann, wenn am Gatter 27 ein Auswahlsignal anliegt, das Pixelsignal des Signalsammelknotens 24 auf die Pixelausgangsleitung 28 treiben.

Fällt Licht 14 auf das TFA-System, so generiert das Licht einen Photostrom 15, der auf dem Signalsammelknoten 24 gesammelt wird. Neben dem Photostrom werden auch alle von Beleuchtung unabhängigen Leckströme, sogenannte Dunkelströme gesammelt. Dazu gehören neben dem Leckstrom des Dünnschichtsystems 16 auch die Leckströme, die im ASIC auftreten. Das sind beispielsweise hier zum einen die Leckströme 31, die von der dem Signalsammelknoten 24 zugeordneten Diffusionsgebiet 21 ins Substrat 20 abfließen. Zum anderen sind das Leckströme 30, die ausgehend von demselben Diffusionsgebiet 21 unter dem Resetgate 22 zum gegenüberliegenden Diffusionsgebiet 21a fließen. Weitere Leckstromquellen sind denkbar, auch wenn sie in diesem Beispiel nicht aufgeführt sind.

Bei der erfindungsgemäßen Realisierung des TFA-Bildsensors durch Verwendung eines Bildsensorprozesses als Basisprozess werden durch besondere Herstellungsverfahren die Leckströme des ASICs 30, 31 reduziert. Die weiteren Modif'ikationen des Bildsensorprozesses gegenüber dem Standardprozess sind für die Erfindung nicht erheblich, wenn sie auch für eine vorteilhafte Realisierung des TFA-Bildsensors von Bedeutung sein können.

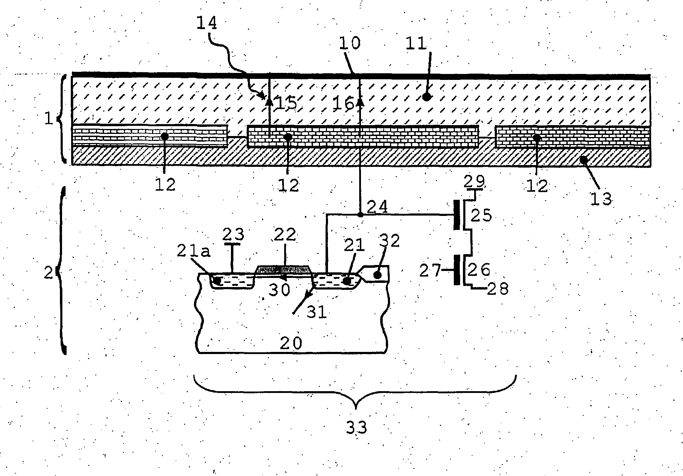

Da sich der erfindungsgemäße TFA-Bildsensor auf Basis eines Bildsensorprozesses in der prinzipiellen Struktur nicht unterscheidet von dem TFA-Bildsensor nach dem Stand der Technik, zeigt Fig. 1 also auch den erfindungsgemäßen TFA-Bildsensor. Die im Einzelnen verwendeten Verfahren zur Reduktion der Leckströme 30, 31, die auf das Diffusionsgebiet 21, das Gate 22, das Substrat 20 oder andere den Sammelknoten 24 umgebende, leckstrambeitragende Strukturen, wie die Isolationsschicht 32 und andere, angewendet werden, können sehr unterschiedlich sein und lassen sich in dieser prinzipiellen Zeichnung nicht darstellen.

Beispielsweise könnte die Implantation der Transistorstrukturen des Pixels 33 der Diffusionsgebiete 21 variiert werden, das Material des Gate 22 variiert werden, das Substrat 20 speziell präpariert werden oder die Ausformung der umgebenden Isolationsschicht 32 auf niedrigen Leckstrom optimiert werden.

### Bezugszeichenliste

- 1: TFA-System
- 2: Kristalliner ASIC

- 10: Frontelektrode
- 11: Dünnschichtmaterial
- 12: Metallische Rückelektrode
- 13: Isolationsschicht
- 14: Licht
- 15: Photostrom
- 16: Leckstrom des Dünnschichtsystems

- 20: Substrat
- 21: Diffusionsgebiet (Drain)
- 21a: Diffusionsgebiet (Source)
- 22: Reset-Gate
- 23: Resetleitung
- 24: Signälsammelknoten
- 25: Treibertransistor
- 26: Auswahltransistor
- 27: Auswahlsignal
- 28: Pixelausgangsleitung
- 29: Versorgungsspannung
- 30: Leckstrom des ASIC
- 31: Leckstrom des ASIC
- 32: Isolationsschicht
- 33: Transistorstruktur des Pixels

## Patentansprüche

1. Verfahren zur Herstellung von Bildsensoren auf der Basis der TFA-Technologie mit einem amorphen Dünnschichtsystem, enthaltend ein Dünnschichtmaterial (11) zur Bildung der Photodioden, das auf einem kristallinen ASIC aufgebracht worden ist, in dem Transistorstrukturen zur Steuerung der Photodiodenfunktion ausgebildet sind, die über Signalsammelknoten (24) mit Photodioden verbunden sind, die im Dünnschichtmaterial (11) pixelweise ausgebildet über Rückelektroden (12) jeweils mit Transistorstrukturen (33) im ASIC (2) verbunden sind, wobei sämtliche Photo- und Leckströme in dem Signalsammelknoten (24) sowie der direkt daran angeschlossenen Elemente zu einem Pixelsignal gesammelt werden und im kristallinen Substrat (2) der Pixelstruktur ein Resettransistor (20) ausgebildet ist, der Drain- und Sourcediffusionsgebiete (21, 21a) und ein Gate (22) umfasst, die von benachbarten Strukturen durch eine Isolationsschicht (32) getrennt sind und **dadurch gekennzeichnet, dass** die Transistoren (20, 25, 26) im kristallinen Substrat (20) in tiefen Ebenen des Substrates mit unterschiedlichen Schwellspannungen ausgebildet werden.

2. Verfahren nach Anspruch 1, **dadurch gekennzeichnet, dass** die Transistorstrukturen (33) im kristallinen ASIC durch einen CMOS-Prozess hergestellt werden.

3. verfahren nach Anspruch 1 oder 2, **dadurch gekennzeichnet, dass** das Dünnschichtsystem auf einem Detektor basiert, der aus amorphem Silizium hergestellt worden ist.

4. Verfahren nach einem der Ansprüche 1 bis 3, **dadurch gekennzeichnet, dass** die Photodioden im Dünnschichtmaterial (11) bildpunktweise in einer zweidimensionalen Matrix angeordnet werden.

5. verfahren nach einem der Ansprüche 1 bis 3, **dadurch gekennzeichnet, dass** die Photodioden im Dünnschichtmaterial (11) bildpunktweise in einer oder mehreren eindimensionalen zeilen angeordnet werden.

6. Verfahren nach einem der Ansprüche 1 bis 5, **dadurch gekennzeichnet, dass** die Transistorstrukturen (33) je eines Pixels unterschiedliche Schwellspannungen aufweisen.

## Claims

1. Method for the manufacture of image sensors based on TFA technology with an amorphous thin film system, comprising a thin film material (11) for forming the photodiodes, which has been applied to a crystalline ASIC, in which transistor structures are formed to control the photodiode function, which by means of signal collecting nodes (24) are connected to photodiodes, which are formed in pixel manner in the thin film material (11) connected in each case by means of back electrodes (12) to transistor structures (33) in the ASIC (2), wherein all of the photo-currents and leak currents in the signal collecting nodes (24) and of the elements directly joined to them are accumulated to one pixel signal and in the crystalline substrate (2) of the pixel structure a reset transistor, (20) is formed which comprises drain and source diffusion regions (21, 21a) and a gate (22) which are separated from adjacent structures by an isolation layer (32), and **characterised in that** the transistors (20, 25, 26) in the crystalline substrate (20) are formed with different threshold voltages in deep levels of the substrate.

2. Method according to Claim 1, **characterised in that** the transistor structures (33) in the crystalline ASIC are manufactured by a CMOS process.

3. Method according to Claim 1 or 2, **characterised in that** the thin film system is based on a detector which has been manufactured from amorphous silicon.

4. Method according to any one of Claims 1 to 3, **characterised in that** the photodiodes in the thin film material (11) are arranged in pixel manner in a two-dimensional matrix.

5. Method according to any one of Claims 1 to 3, **characterised in that** the photodiodes in the thin film material (11) are arranged in pixel manner in one or more one-dimensional lines.

6. Method according to any one of Claims 1 to 5, **characterised in that** the transistor structures (33) of each individual pixel have different threshold voltages.

## Revendications

1. Procédé de fabrication de capteurs d'images en technique TFA comportant un système amorphe à couche mince avec une matière de couche mince (11) pour former les photodiodes, ce système étant installé sur un circuit ASIC cristallin, muni de structures de transistors pour commander le fonctionnement des photodiodes, ces structures étant reliées par des noeuds de collecte de signaux (24) aux photodiodes réalisées comme pixels dans la matière de la couche mince (11) en étant reliées par des électrodes arrière (12) chaque fois aux structures de transistors (33) du circuit ASIC (2),
selon lequel tous les courants de photos et de fuite des noeuds de collecte de signaux (24) ainsi que ceux des éléments directement raccordés sont collectés en un signal de pixels et un transistor de remise à l'état initial (20) est réalisé dans le substrat cristallin (2) de la structure de pixels, ce transistor ayant des zones de diffusion de drain et de source (21, 21a) et une porte (22) séparées des structures voisines par une couche d'isolation (32),
**caractérisé en ce que**
les transistors (20, 25, 26) sont réalisés dans le substrat cristallin (20) dans les plans profonds du substrat avec des tensions de seuil différentes.

2. Procédé selon la revendication 1,
**caractérisé en ce que**
les structures de transistors (33) du circuit ASIC cristallin sont réalisées en technique CMOS.

3. Procédé selon les revendications 1 ou 2,
**caractérisé en ce que**
le système de couche mince est fondé sur un détecteur en silicium amorphe.

4. Procédé selon l'une des revendications 1 à 3,
**caractérisé en ce que**
les photodiodes sont prévues dans la matière de couche mince (11) sous la forme de points répartis dans une matrice à deux dimensions.

5. Procédé selon l'une des revendications 1 à 3,
**caractérisé en ce que**
les photodiodes sont prévues dans la matière de couche mince (11) de façon ponctuelle avec une répartition en une ou plusieurs lignes à une dimension.

6. Procédé selon l'une des revendications 1 à 5,
**caractérisé en ce que**
les structures de transistor (33) de chaque pixel ont des tensions de seuil différentes.
